# EUROPEAN PATENT APPLICATION

(11) **EP 4 542 660 A1**
(43) Date of publication of application: **23.04.2025**
(21) Application number: 23306838.6
(22) Date of filing: 19.10.2023
(51) Int. Cl.: H01L 31/107

(54) **SINGLE-PHOTON AVALANCHE DIODE**

(71) Applicant: STMicroelectronics International N.V., 1228 Plan-les-Ouates, Geneva (CH)
(72) Inventor: NICHOLSON, Isobel, EDINBURGH, EH11 1EQ (GB); GOLANSKI, Dominique, 38610 GIERES (FR); MAMDY, Bastien, 38420 LE VERSOUD (FR)
(74) Representative: Cabinet Beaumont

(57) **Abstract**

The present disclosure relates to an avalanche photodiode (20) comprising, in a semiconductor substrate (12):
-a first semiconductor region (14) of a first conductivity type;
-a second semiconductor region (16a) of a second conductivity type forming with the first region (14) a PN junction (19) configured to being reverse-biased;
-a third semiconductor region (16b) of the second conductivity type, the second region (16a) being closer to the first region (14) than the third region (16b) ; and
-a fourth semiconductor region (16d) of the second conductivity type in contact with the second and third regions (16a, 16b) having a dopant concentration inferior to the dopant concentrations of the second and third regions (16a, 16b), said fourth region (16d) being arranged to at least partially surround the second region (16a), and said third region (16b) being arranged to at least partially surround the fourth region (16d).

## Description

### Technical field

The present disclosure generally concerns avalanche photodiodes, in particular single photon avalanche diodes.

### Background art

A single-photon avalanche diode (SPAD) is essentially formed by a PN junction reversely biased at a voltage higher than the breakdown voltage, or avalanche voltage, of the junction. At this bias voltage, the electric field is high enough that a single charge carrier injected into the depletion layer of the junction can trigger a self-sustaining avalanche. A single photon is thus capable of generating a measurable electric signal, and this, with a very short response time. SPADs enable to detect radiations of very low luminous intensity, and are in particular used for the detection of single photons and the counting of photons.

It would be desirable to be able to at least partly improve certain aspects of known SPADs.

### Summary of Invention

One embodiment addresses all or some of the drawbacks of known SPADs.

An embodiment provides an avalanche photodiode comprising, in a semiconductor substrate:
- a first semiconductor region of a first conductivity type;
- a second semiconductor region of a second conductivity type forming with the first semiconductor region a PN junction configured to being reverse-biased;
- a third semiconductor region of the second conductivity type, the second semiconductor region being closer to the first semiconductor region than the third semiconductor region; and
- a fourth semiconductor region of the second conductivity type in contact with the second and third semiconductor regions having a dopant concentration inferior to the dopant concentrations of the second and third semiconductor regions, said fourth semiconductor region being arranged to at least partially surround the second semiconductor region, and said third semiconductor region being arranged to at least partially surround the fourth semiconductor region.

According to an embodiment, the fourth semiconductor region completely surrounds the second semiconductor region, and the third semiconductor region completely surrounds the fourth semiconductor region.

According to an embodiment, the avalanche photodiode further comprises a fifth semiconductor region of the second conductivity type surrounding the first semiconductor region and the second semiconductor region and in contact with the third semiconductor region.

According to an embodiment, the second semiconductor region is more heavily doped than the third semiconductor region.

According to an embodiment, the fifth semiconductor region is more heavily doped than the third semiconductor region.

According to an embodiment, the substrate comprises a surface, the first semiconductor region crops out at said surface, and the first semiconductor region is interposed between said surface and the second semiconductor region.

According to an embodiment, each dimension of the avalanche photodiode, in a plane parallel to said surface, is smaller than 6 µm and/or the height of the avalanche photodiode is in the range from 3 µm to 15 pm, for example in the range from 6 µm to 10 µm.

According to an embodiment, the dopant concentrations of the second semiconductor region and the third semiconductor region are higher than 4*10¹⁶ atoms/cm³ and the dopant concentration of the fourth semiconductor region is lower than 4*10¹⁶ atoms/cm³.

Another embodiment provides a method of manufacturing an avalanche photodiode comprising, in a semiconductor substrate:
- a first semiconductor region of a first conductivity type;
- a second semiconductor region of a second conductivity type forming with the first semiconductor region a PN junction adapted to being reverse-biased;
- a third semiconductor region of the second conductivity type, the second semiconductor region being closer to first semiconductor region than the third semiconductor region; and
- a fourth semiconductor region of the second conductivity type in contact with the second and third semiconductor regions having a dopant concentration inferior to the dopant concentrations of the second and third semiconductor regions, said fourth semiconductor region being arranged to at least partially surround the second semiconductor region, and said third semiconductor region being arranged to at least partially surround the fourth semiconductor region.

According to an embodiment, the method comprises a first step of implantation of dopants in the substrate for forming the third semiconductor region and a second step of implantation of dopants in the substrate for forming the second semiconductor region, the fourth semiconductor region resulting from the first and second implantation steps.

### Brief description of drawings

The foregoing features and advantages, as well as others, will be described in detail in the following description of specific embodiments given by way of illustration and not limitation with reference to the accompanying drawings, in which:
Figure 1 is a partial simplified lateral cross-section view of an example of a SPAD;
Figure 2 is a partial simplified lateral cross-section view of an embodiment of a SPAD;
Figure 3 is a partial simplified top view of the SPAD of Figure 2;
Figure 4 is a partial simplified lateral cross-section view of the SPAD shown in Figure 1 illustrating, in grey scale, the variations of the breakdown probability in the SPAD;
Figure 5 is a partial simplified lateral cross-section view of the SPAD shown in Figure 2 illustrating, in grey scale, the variations of the breakdown probability in the SPAD;
Figure 6 is a partial simplified lateral cross-section view of the SPAD shown in Figure 1 illustrating electric field lines in the SPAD; and
Figure 7 is a partial simplified lateral cross-section view of the SPAD shown in Figure 2 illustrating electric field lines in the SPAD.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail. In particular, a SPAD photodiode generally comprises secondary circuits, particularly a circuit for biasing the PN junction to a voltage higher than its avalanche threshold, a readout circuit adapted to detecting the starting of an avalanche of the photodiode, as well as a quenching circuit having the function of interrupting the avalanche of the photodiode once it has started. These secondary circuits have not been shown in the drawings and will not be detailed, the described embodiments being compatible with secondary circuits equipping known SPAD photodiodes.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10%, and preferably within 5%.

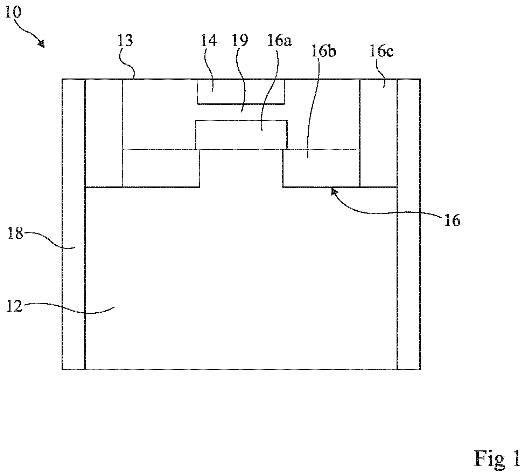

Figure 1 is a partial simplified lateral cross-section view of an example of a single-photon avalanche diode 10 (SPAD), configured to start an avalanche on detection of a photon. Figure 1 represents a substrate 12 on and in which SPAD 10 is formed. Substrate 12 is a semiconductor substrate, for example in silicon, having an upper surface 13.

SPAD 10 comprises a cathode 14 and an anode 16. SPAD 10 can be surrounded by a wall 18. Cathode 14 is a n-doped semiconductor region. Cathode 14 for example crop out at upper surface 13 of the substrate 12. In other words, the upper face of cathode 14 is coplanar with the upper face of the substrate 12.

The anode 16 comprises a region 16a, a region 16b and a region 16c. Region 16a is a p-doped semiconductor region and is called p-well hereafter. P-well 16a is for example buried in the substrate 12. Region 16b is a p-doped semiconductor region that surrounds p-well 16a and is called p-ring hereafter. P-ring 16b is for example buried in the substrate 12. P-ring 16b is preferably located under p-well 16a. In other words, p-well 16a is preferably located between p-ring 16b and cathode 14. Region 16c is a p-doped semiconductor region. Region 16c extends vertically in substrate 12. Region 16c extends from upper surface 13 of substrate 12 at least to p-ring 16b. For example, the P-type regions are doped with boron atoms (B), and/or the N-type regions are doped with arsenic atoms (As).

The p-n junction 19 of SPAD 10 is located between cathode 14 and p-well 16A. In operation, junction 19 of SPAD 10 is biased well above its reverse-bias breakdown voltage.

The structure of anode 16 with p-well 16a, p-ring 16b and region 16c provides a low resistance path for the anode voltage to the center of SPAD 10, provides a low resistance path for hole evacuation, and guides electrons into the center of the SPAD 10.

In SPAD 10, p-ring 16b and p-well 16a are in contact. Part of the upper face of p-ring 16b is in contact with the lower face of p-well 16a.

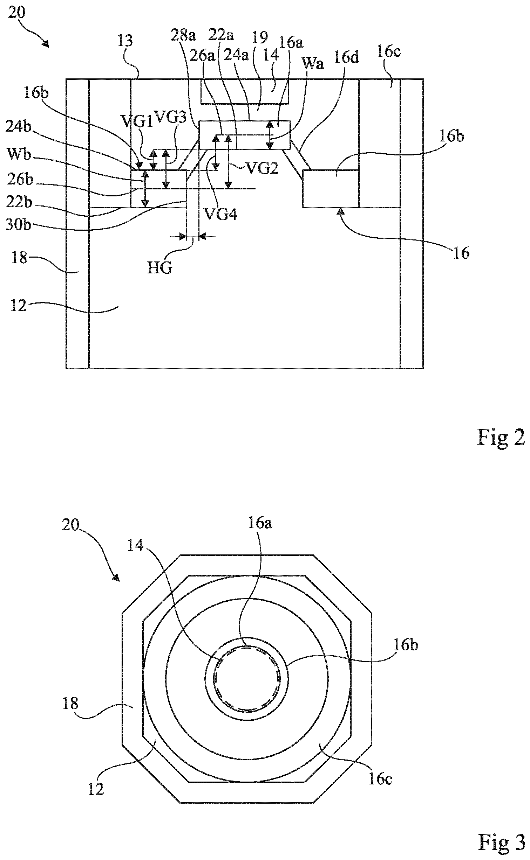

Figure 2 is a partial simplified lateral cross-section view of an embodiment of a single-photon avalanche diode 20 (SPAD), configured to start an avalanche on detection of a photon.

SPAD 20 shown in Figure 2 comprises all the elements of SPAD 10 shown in Figure 1 except that p-well 16a is not in contact with p-ring 16b so that there is a p-doped region 16d linking p-well 16a and p-ring 16b having a dopant concentration inferior to the dopant concentrations of p-well 16a and p-ring 16b. According to an embodiment, the maximum dopant concentration of p-doped region 16d is inferior to 25% of the maximum dopant concentration of p-well 16a and inferior to 40% of the maximum dopant concentration of p-ring 16b.

P-well 16a comprises a lower surface 22a and an upper surface 24a. The thickness Wa of p-well 16a corresponds to the distance between lower surface 22a and upper surface 24a. P-well 16a also comprises a center plane 26a that is at mid-distance between lower surface 22a and upper surface 24a. As an example, lower surface 22a is defined as the plane surface that is parallel to upper surface 13, that is the farthest to upper surface 13, and that is tangent to the contour of p-well 16a having a dopant concentration at a first fixed value and upper surface 24a is defined as the plane surface that is parallel to upper surface 13, that is the closest to upper surface 13 and that is tangent to the contour of p-well 16a having a dopant concentration at the first fixed value.

P-ring 16b comprises a lower surface 22b and an upper surface 24b. The thickness Wb of p-well 16a corresponds to the distance between lower surface 22a and upper surface 24a. P-well 16a also comprises a center plane 26b that is at mid-distance between lower surface 22b and upper surface 24b. As an example, lower surface 22b is defined as the plane surface that is parallel to upper surface 13, that is the farthest to upper surface 13, and that is tangent to the contour of p-ring 16b having a dopant concentration at a second fixed value and upper surface 24b is defined as the plane surface that is parallel to upper surface 13, that is the closest to upper surface 13 and that is tangent to the contour of p-ring 16b having a dopant concentration at the second fixed value. The second fixed value is equal to the first fixed value or is different from the first fixed value. P-ring 16b also comprises an inner lateral surface 30b. As an example, inner lateral surface 30b of p-ring 16b is defined as the surface that is orthogonal to upper surface 13 of substrate 12, that is the farthest of wall 18, and that is tangent to the contour of p-ring 16b having a dopant concentration at the second fixed value.

P-well 16a comprises an outer lateral surface 28a. As an example, outer lateral surface 28a of p-well 16a is defined as the surface that is orthogonal to upper surface 13 of substrate 12, that is the closest to wall 18 and that is tangent to the contour of p-well 16a having a dopant concentration at the first fixed value.

Each region 16a, 16b, 16c has preferably a doping concentration substantially constant. According to an embodiment, the dopant concentration of region 14 is in the range from 5*10¹⁷ atoms/cm³ to 5*10¹⁹ atoms/cm³, the dopant concentration of p-well 16a is in the range from 1*10¹⁶ atoms/cm³ to 5*10¹⁷ atoms/cm³, the dopant concentration of region 16c is in the range from 5*10¹⁷ atoms/cm³ to 5*10¹⁹ atoms/cm³, the dopant concentration of p-ring 16b is in the range from 1*10¹⁶ atoms/cm³ to 5*10¹⁷ atoms/cm³, the dopant concentration of region 16d is in the range from 1*10¹⁵ atoms/cm³ to 1*10¹⁷ atoms/cm³. According to an embodiment, when moving from p-well 16a to p-ring 16b through region 16d, the dopant concentration is at least at one time inferior to than 5*10¹⁶ atoms/cm³. The dopant concentration of p-well 16a is for example higher than the dopant concentration in p-ring 16b. The dopant concentration of p-ring 16b is for example lower than the dopant concentration in region 16c. Substrate 12 is can be n-doped or p-doped. According to an embodiment, the dopant concentration of substrate 12 is in the range from 1*10¹⁰ atoms/cm³ to 1*10¹⁶ atoms/cm³.

Lower surface 22a of p-well 16a is separated from upper surface 24b of p-ring 16b by distance VG1, called first vertical gap hereafter. Center plane 26a of p-well 16a is separated from center plane 26b of p-ring 16b by distance VG2, called second vertical gap hereafter. Lower surface 22a of p-well 16a is separated from center plane 26b of p-ring 16b by distance VG3, called third vertical gap hereafter. Center plane 26a of p-well 16a is separated from upper surface 24b of p-ring 16b by distance VG4, called fourth vertical gap hereafter.

Outer lateral surface 28a of p-well 16a is separated from inner lateral surface 30b of p-ring 16b by distance HG, called horizontal gap hereafter.

An embodiment of a method for manufacturing SPAD 20 comprises a first step of implantation of dopants in substrate 12 to form p-ring 16b and a second step of implantation of dopants in substrate 12 to form p-well 16a. Region 16d linking p-well 16a and p-ring 16b results from the implantation steps performed for making p-well 16a and p-ring 16b.

According to an embodiment, the first and fixed values correspond to a dopant concentration equal to 5*10¹⁶ atoms/cm³. According to an embodiment, horizontal gap HG is in the range from 0.1 µm to 0.5 µm, preferably from 0.05 µm to 0.3 µm. According to an embodiment, first vertical gap VG1 is in the range from 0 µm to 2 pm, preferably from 0.9 µm to 1.5 µm. According to an embodiment, second vertical gap VG2 is in the range from 0.1 µm to 2.6 µm. According to an embodiment, third vertical gap VG3 is in the range from 0.05 µm to 2.3 µm. According to an embodiment, fourth vertical gap VG4 is in the range from 0.05 µm to 2.3 µm. According to an embodiment, thickness Wa of p-well 16a is in the range from 0.05 µm to 0.3 µm. According to an embodiment, thickness Wb of p-ring 16b is in the range from 0.05 µm to 0.3 µm.

Figure 3 is a partial simplified bottom view of SPAD 20 of Figure 2 showing, in solid line, the outlines of regions 16a, 16b, and 16c and walls 18 and in dotted line the outlines of region 14.

Cathode 14 for example has a cylindrical form. For example, cathode 14 has, in the top view, a circular form. Alternatively, cathode 14 has, in the top view, the form of a rectangle, preferably a square, with smoothed angles.

P-well 16a for example has a cylindrical form. For example, p-well 16a has, in a top view, a circular form. Alternatively, p-well 16a has, in the top view, the form of a rectangle, preferably a square, with smoothed angles. P-ring 16b has for example the form of a ring. P-ring 16b laterally surrounds a portion of the substrate 12 vertically aligned with p-well 16a.

Regions 16b and 16c are in contact, for example laterally. The upper face of the region 16c is for example coplanar with upper surface 13 of substrate 12. Region 16c surrounds cathode 14, and regions 16a and 16b. Region 16c is separated from cathode 14 by a portion of substrate 12.

P-well 16a is for example located under region 14. In other words, at least part of p-well 16a is vertically aligned with a part of region 14. P-well 16a can be separated from region 14 by a portion of substrate 12. As a variation, p-well 16a can be in contact with region 14.

Preferably, wall 18 extends, vertically, on the entire height of SPAD 20. Preferably, wall 18 extends, vertically, at least from the point of cathode 14 and anode 16 the closest to upper surface 13 of substrate 12 to the point of cathode 14 and anode 16 the farthest to upper surface 13 of substrate 12. In other words, in the example of Figure 2, wall 18 extends, vertically, at least from the upper surface of cathode 14, corresponding to upper surface 13 of substrate 12 and to the upper face of region 16c, to the lower face of substrate 12.

According to an embodiment, wall 18 has, in top view, in other words in the plan of upper surface 13 of substrate 12, an octagonal form. In other words, the internal lateral face of wall 18, meaning the lateral face of wall 18 the closest to SPAD 20, has the form of an octagon. The SPAD region, in other words the region of substrate 12 in which the SPAD is formed, is bordered by wall 18. Said portion therefore has an octagonal profile. As a variation, wall 18 has, in top view, in other words in the plan of upper surface 13 of substrate 12, an annular form.

Preferably, walls 18 are electrically and optically insulating. Walls 18 are for example of the back-side deep trench insulation (BDTI) type. Walls 18 for example comprises a sheath in an electrically insulating material and a core in an optically insulating material, for example in metal. By optically insulating material, it is meant a material at least partially opaque, preferably entirely opaque, to the working wavelength of the SPAD, for example all wavelength of the visible range and/or all wavelength of the near infrared range. Walls 18 are electrically insulating. Walls 18 are for example of the deep trench insulating (DTI) type. Walls 18 are for example in an oxide, for example in silicon oxide. Alternatively, walls 18 can also be of the back-side deep trench insulation (BDTI) type.

For example, SPAD 20 is comprised, in top view, in a square having a side length, for example, smaller than approximately 6 µm. For example, the height of photodiode 100 is in the range from approximately 3 µm to 15 pm, for example equal to approximately 6 µm or to approximately 10 µm.

For a device comprising an array of SPAD, the pitch of the SPADs corresponds to the distance, in a top view, between the centers of two adjacent SPADs. According to an embodiment, the pitch of the SPAD is in the range from 3 µm to 12 µm. Pitch of the SPADs is slightly superior to the lateral dimension of the SAPD.

For example, the parts of substrate 12 below p-well 16a and p-ring 16b form a collection volume within which carriers have a significant probability of being generated on absorption of a photon (photogenerated). When no electric charge is present in the depletion area or space charge area of the PN junction 19 of SPAD 10 or 20, the photodiode is in a pseudo-stable non-conductive state. When a photogenerated electric charge is injected into the depletion area, if the displacement speed of this charge in the depletion area is sufficiently high, that is, if the electric field in the depletion area is sufficiently intense, the charge is likely to trigger a self-sustaining avalanche. A single photon is thus capable of generating a measurable electric signal, and this, with a very short response time. The current continues until the avalanche is quenched. To that end, the SPAD is associated with a quenching circuit that is configured to reduce the voltage across the SPAD to stop the avalanche and reset the SPAD.

Electronic devices may comprise a plurality of SPADs. For example, an image sensor is an electronic device comprising a pixel array, each pixel comprising at least one SPAD. The SPADs enable the image sensor to obtain image of a scene at a given time. An example of application of SAPD is in a time-of-flight imaging device.

Simulations have been carried out by the inventors with SPAD 10 having the structure shown in Figure 1 and with SPAD 20 having the structure shown in Figure 2.

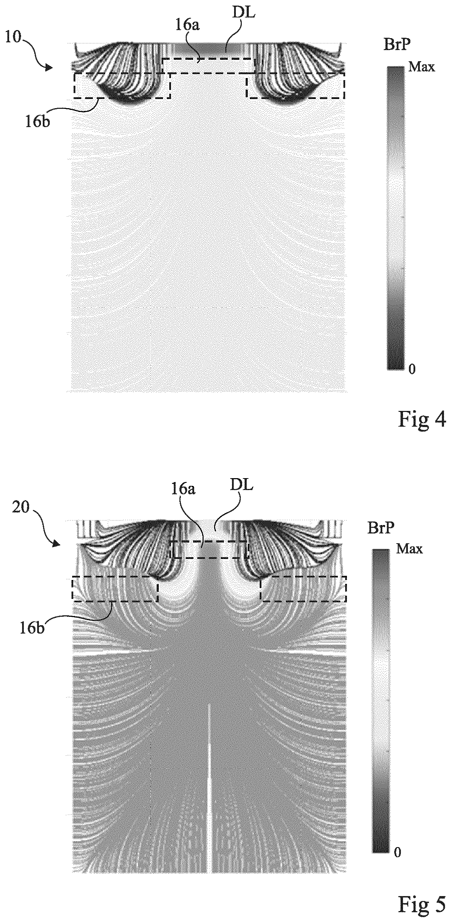

Figure 4 is a partial simplified lateral cross-section view of SPAD 10 shown in Figure 1 illustrating, in grey scale, the variations of the breakdown probability BrP in SPAD 10 and figure 5 is a partial simplified lateral cross-section view of SPAD 20 shown in Figure 2 illustrating, in grey scale, the variations of the breakdown probability BrP in SPAD 20. For Figures 4 and 5, the grey scale for breakdown probability BrP is indicated without unit from 0 to a maximal value. In Figures 4 and 5, the outlines of p-well 16a and p-ring 16b are schematically shown in dotted line. Moreover, the depletion layer of the junction is indicated by reference DL.

Breakdown probability BrP is the likelihood that an electron that is photo-generated in the SPAD will cause an avalanche in depletion layer DL. A photogenerated carrier will on average follow the trajectory of the electric field lines to the junction of the SPAD, where it will break down with the probability BrP given by the grey level of the field line at its start point. It is desirable for the breakdown probability to be high.

In the simulations, breakdown probability BrP is determined along the electric field lines when the p-n junction of SPAD 10 or 20 is at the breakdown voltage equal to 4 V. It is desirable that breakdown probability BrP to be high in the biggest part of the SPAD. The average breakdown probability of SPAD 10 is at about 30%. The average breakdown probability of SPAD 20 is at about 45%.

Figure 5 also shows that, despite the gap between p-well 16a and p-ring 16b, the carrier evacuation paths in SPAD 20 are still focused to the center of SPAD 20 by p-ring 16b.

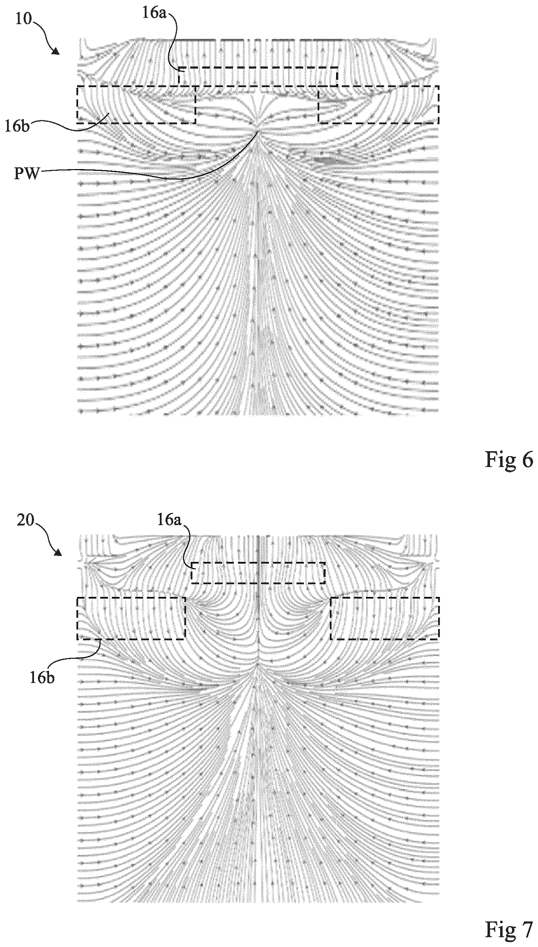

Figure 6 is a partial simplified lateral cross-section view of SPAD 10 shown in Figure 1 illustrating electric field lines in SPAD 10 and figure 7 is a partial simplified lateral cross-section view of SPAD 20 shown in Figure 2 illustrating electric field lines in SPAD 20. In Figures 6 and 7, the outlines of p-well 16a and p-ring 16b are schematically shown in dotted line. For Figures 6 and 7, the p-n junction of the SPAD 10 or 20 is at a voltage inferior to the breakdown voltage, for example at 19 V, and the SPAD 10 or 20 operates at a temperature equal to -20 °C. Figures 6 and 7 illustrate operation conditions during the quenching of the SPAD.

Figure 6 shows that the electric field lines form a potential well PW for SPAD 10 whereas there is no potential well for SPAD 20. The presence of potential well PW means that carriers can become trapped in the device when the electric field is reduced during quenching, which may result in the resetting of SPAD 10 not working correctly. This risk is reduced for SPAD 20.

Various embodiments and variants have been described. Those skilled in the art will understand that certain features of these embodiments can be combined and other variants will readily occur to those skilled in the art.

Finally, the practical implementation of the embodiments and variants described herein is within the capabilities of those skilled in the art based on the functional description provided hereinabove.

## Claims

1. Avalanche photodiode (20) comprising, in a semiconductor substrate (12):
- a first semiconductor region (14) of a first conductivity type;
- a second semiconductor region (16a) of a second conductivity type forming with the first semiconductor region (14) a PN junction (19) configured to being reverse-biased;
- a third semiconductor region (16b) of the second conductivity type, the second semiconductor region (16a) being closer to the first semiconductor region (14) than the third semiconductor region (16b); and
- a fourth semiconductor region (16d) of the second conductivity type in contact with the second and third semiconductor regions (16a, 16b) having a dopant concentration inferior to the dopant concentrations of the second and third semiconductor regions (16a, 16b), said fourth semiconductor region (16d) being arranged to at least partially surround the second semiconductor region (16a), and said third semiconductor region (16b) being arranged to at least partially surround the fourth semiconductor region (16d).

2. Avalanche photodiode according to claim 1, wherein the fourth semiconductor region (16d) completely surrounds the second semiconductor region (16a), and wherein the third semiconductor region (16b) completely surrounds the fourth semiconductor region (16d).

3. Avalanche photodiode according to claim 1 or 2, further comprising a fifth semiconductor region (16c) of the second conductivity type surrounding the first semiconductor region (14) and the second semiconductor region (16a) and in contact with the third semiconductor region (16b).

4. Avalanche photodiode according to any of claims 1 to 3, wherein the second semiconductor region (16a) is more heavily doped than the third semiconductor region (16b).

5. Avalanche photodiode according to claim 3, wherein the fifth semiconductor region (16c) is more heavily doped than the third semiconductor region (16b).

6. Avalanche photodiode according to any of claims 1 to 5, wherein the substrate (12) comprises a surface (13), wherein the first semiconductor region (14) crops out at said surface (13), and wherein the first semiconductor region (14) is interposed between said surface (13) and the second semiconductor region (16a).

7. Avalanche photodiode according to claim 6, wherein each dimension of the avalanche photodiode, in a plane parallel to said surface (13), is smaller than 6 µm and/or the height of the avalanche photodiode is in the range from 3 µm to 15 pm, for example in the range from 6 µm to 10 pm.

8. Avalanche photodiode according to any of claims 1 to 7, wherein the dopant concentrations of the second semiconductor region (16a) and the third semiconductor region (16c) are higher than 4*10¹⁶ atoms/cm³ and the dopant concentration of the fourth semiconductor region (16d) is lower than 4*10¹⁶ atoms/cm³.

9. Method of manufacturing an avalanche photodiode (20) comprising, in a semiconductor substrate (12):
- a first semiconductor region (14) of a first conductivity type;
- a second semiconductor region (16a) of a second conductivity type forming with the first semiconductor region (14) a PN junction (19) adapted to being reverse-biased;
- a third semiconductor region (16b) of the second conductivity type, the second semiconductor region (16a) being closer to first semiconductor region (14) than the third semiconductor region (16b); and
- a fourth semiconductor region (16d) of the second conductivity type in contact with the second and third semiconductor regions (16a, 16b) having a dopant concentration inferior to the dopant concentrations of the second and third semiconductor regions (16a, 16b), said fourth semiconductor region (16d) being arranged to at least partially surround the second semiconductor region (16a), and said third semiconductor region (16b) being arranged to at least partially surround the fourth semiconductor region (16d).

10. Method according to claim 9, comprising a first step of implantation of dopants in the substrate (12) for forming the third semiconductor region (16b) and a second step of implantation of dopants in the substrate (12) for forming the second semiconductor region (16a), the fourth semiconductor region (16d) resulting from the first and second implantation steps.
